# EUROPEAN PATENT APPLICATION

(11) **EP 4 393 892 A1**
(43) Date of publication of application: **03.07.2024**
(21) Application number: 22861061.4
(22) Date of filing: 29.07.2022
(51) Int. Cl.: C03C 3/091, C03C 3/089, H01L 23/12

(54) **SUPPORT GLASS SUBSTRATE, MULTI-LAYER BODY, METHOD FOR PRODUCING MULTI-LAYER BODY, AND METHOD FOR PRODUCING SEMICONDUCTOR PACKAGE**

(30) Priority: 24.08.2021 JP 2021136408; 02.03.2022 JP 2022031381
(71) Applicant: Nippon Electric Glass Co., Ltd., Otsu-shi, Shiga 520-8639 (JP)
(72) Inventor: TAKEDA, Miyako, Otsu-shi Shiga 520-8639 (JP)
(74) Representative: Tetzner, Michael
(86) International application number: PCT/JP2022/029328
(87) International publication number: WO 2023/026770

(57) **Abstract**

A support glass substrate of the present invention is a support glass substrate for supporting a substrate to be processed, the support glass substrate including, as a glass composition, in terms of mol%, 50% to 80% of SiO₂, 0% to 25% of Al₂O₃, 5.5% to 20% of B₂O₃, 0% to 5% of Li₂O+Na₂O+K₂O, 0% to 15% of MgO, 1% to 25% of CaO, 0% to 10% of SrO, and 0% to 10% of BaO, having a molar ratio (MgO+SrO+BaO)/CaO of 1.5 or less, and having an average coefficient of thermal expansion at from 30°C to 380°C of from 35×10⁻⁷/°C to 60×10⁻⁷/°C.

## Description

### Technical Field

The present invention relates to a support glass substrate, a laminate, a method of manufacturing a laminate, and a method of manufacturing a semiconductor package.

### Background Art

Portable electronic devices, such as a cellular phone, a notebook-size personal computer, and a personal data assistance (PDA), are required to be downsized and reduced in weight. Along with this, a mounting space for semiconductor chips to be used in those electronic devices is strictly limited, and there is a problem of high-density mounting of the semiconductor chips. In view of this, in recent years, there has been an attempt to perform high-density mounting of a semiconductor package by a three-dimensional mounting technology, that is, by laminating semiconductor chips on top of another and connecting the semiconductor chips through wiring.

In addition, a conventional wafer level package (WLP) is manufactured by forming bumps into a wafer shape and dicing the wafer into chips. However, the conventional WLP has problems in that it is difficult to increase the number of pins, and chipping and the like of semiconductor chips are liable to occur because the semiconductor chips are mounted under a state in which the back surfaces thereof are exposed.

Accordingly, as a new WLP, a fan-out type WLP has been proposed. In the fan-out type WLP, it is possible to increase the number of pins, and chipping and the like of semiconductor chips can be prevented by protecting end portions of the semiconductor chips.

A method of manufacturing the fan-out type WLP includes, for example, after arraying a plurality of semiconductor chips on a support glass substrate and then molding the plurality of semiconductor chips with a sealing material of a resin to form a substrate to be processed, a step of arranging wiring on one surface of the substrate to be processed, and a step of forming solder bumps.

### Summary of Invention

### Technical Problem

In some cases, the support glass substrate is required to have a coefficient of thermal expansion of from 35×10⁻⁷/°C to 60×10⁻⁷/°C so that the coefficient of thermal expansion matches the coefficient of thermal expansion of each of the semiconductor chips.

However, when glass components are adjusted so that the support glass substrate has a coefficient of thermal expansion of from 35×10⁻⁷/°C to 60×10⁻⁷/°C, the Young's modulus of the support glass substrate is reduced, and the reliability of processing treatment of the substrate to be processed may be impaired. In addition, the devitrification resistance of the support glass substrate is reduced, and the productivity thereof is liable to be reduced.

In addition, after the processing treatment of the substrate to be processed, a step of separating the substrate to be processed and the glass support substrate is present. In the step, light at a short wavelength is radiated to a peeling layer through the support glass substrate. Accordingly, the transmittance at a short wavelength (ultraviolet light transmittance) of the support glass substrate is required to be increased, but it is difficult to increase the transmittance thereof at shorter wavelengths.

The present invention has been made in view of the above-mentioned circumstances, and a technical object of the present invention is to provide a support glass substrate, which has a high Young's modulus and high devitrification resistance even when having a low coefficient of thermal expansion, and also has a high transmittance at shorter wavelengths.

### Solution to Problem

The inventor of the present invention has repeated various experiments, and as a result, has found that the above-mentioned technical object can be achieved by strictly restricting the glass composition range of a support glass substrate, particularly by strictly restricting the content ranges of B₂O₃ and CaO. Thus, the finding is proposed as the present invention. That is, according to one embodiment of the present invention, there is provided a support glass substrate for supporting a substrate to be processed, the support glass substrate comprising, as a glass composition, in terms of mol%, 50% to 80% of SiO₂, 0% to 25% of Al₂O₃, 5.5% to 20% of B₂O₃, 0% to 5% of Li₂O+Na₂O+K₂O, 0% to 15% of MgO, 1% to 25% of CaO, 0% to 10% of SrO, and 0% to 10% of BaO, having a molar ratio (MgO+SrO+BaO)/CaO of 1.5 or less, and having an average coefficient of thermal expansion at from 30°C to 380°C of from 35×10⁻⁷/°C to 60×10⁻⁷/°C. Herein, the expression "Li₂O+Na₂O+K₂O" refers to the total content of Li₂O, Na₂O, and K₂O. The expression "(MgO+SrO+BaO)jCaO" refers to a value obtained by dividing the total content of MgO, SrO, and BaO by the content of CaO. The "average coefficient of thermal expansion at from 30°C to 380°C" may be measured with a dilatometer.

In addition, it is preferred that the support glass substrate for supporting a substrate to be processed according to the one embodiment of the present invention comprise, as the glass composition, in terms of mol%, 50% to 70% of SiO₂, 8% to 15% of Al₂O₃, 8% to 14% of B₂O₃, 0% to 5% of Li₂O+Na₂O+K₂O, 0% to 8% of MgO, 7% to 20% of CaO, 0% to 5% of SrO, and 0% to 5% of BaO, and have an average coefficient of thermal expansion at from 30°C to 380°C of from 38×10⁻⁷/°C to 55×10⁻⁷/°C.

In addition, it is preferred that the support glass substrate according to the one embodiment of the present invention have a transmittance at a thickness of 1 mm at 254 nm, that is, an external transmittance of 5% or more.

In addition, it is preferred that the support glass substrate according to the one embodiment of the present invention have an average coefficient of thermal expansion at from 30°C to 380°C of from 40×10⁻⁷/°C to 55×10⁻⁷/°C.

In addition, it is preferred that the support glass substrate according to the one embodiment of the present invention have a Young's modulus of 70 GPa or more. Herein, the "Young's modulus" refers to a value measured by a flexural resonance method.

In addition, it is preferred that the support glass substrate according to the one embodiment of the present invention have a liquidus viscosity of 10^{4.0} dPa·s or more. Herein, the "liquidus viscosity" is a viscosity at a liquidus temperature, and may be measured by a platinum sphere pull up method. The "liquidus temperature" may be calculated by measuring a temperature at which a crystal precipitates when glass powder, which has passed through a standard 30-mesh sieve (500 um) and remained on a 50-mesh sieve (300 um), is placed in a platinum boat and then kept for 24 hours in a gradient heating furnace. The liquidus viscosity is an index of formability. As the liquidus viscosity is higher, the formability is improved more.

In addition, it is preferred that the support glass substrate according to the one embodiment of the present invention have a temperature at a viscosity at high temperature of 10^{2.5} dPa-s of less than 1,600°C. Herein, the "temperature at 10^{2.5} dPa·s" may be measured by a platinum sphere pull up method. The temperature at 10^{2.5} dPa·s corresponds to a melting temperature. As the temperature is lower, the meltability of the support glass substrate is improved more.

In addition, it is preferred that the support glass substrate according to the one embodiment of the present invention have a wafer shape having a diameter of from 100 mm to 500 mm, have a sheet thickness of less than 2.0 mm, have a total thickness variation (TTV) of 5 µm or less, and have a warpage level of 60 µm or less. Herein, the "total thickness variation (TTV)" may be measured with, for example, a Bow/Warp measurement device SBW-331ML/d manufactured by Kobelco Research Institute, Inc. The "warpage level" refers to the total of the absolute value of the maximum distance between the highest point and least squares focal plane of the entire support glass substrate, and the absolute value of the maximum distance between the lowest point and least squares focal plane thereof, and may be measured with, for example, a Bow/Warp measurement device SBW-331M/Ld manufactured by Kobelco Research Institute, Inc.

According to one embodiment of the present invention, there is provided a laminate, preferably comprising at least a substrate to be processed and a support glass substrate for supporting the substrate to be processed, wherein the support glass substrate is the above-mentioned support glass substrate.

In addition, in the laminate according to the one embodiment of the present invention, it is preferred that the substrate to be processed comprise at least a semiconductor chip molded with a sealing material.

According to one embodiment of the present invention, there is provided a method of manufacturing a laminate, preferably comprising the steps of: preparing the support glass substrate described above; preparing a substrate to be processed; and laminating the support glass substrate and the substrate to be processed on each other to obtain a laminate.

According to one embodiment of the present invention, there is provided a method of manufacturing a semiconductor package, preferably comprising the steps of: preparing the laminate described above; and subjecting the substrate to be processed to processing treatment.

In addition, in the method of manufacturing a semiconductor package according to the one embodiment of the present invention, it is preferred that the step of subjecting the substrate to be processed to processing treatment comprise arranging wiring on one surface of the substrate to be processed.

In addition, in the method of manufacturing a semiconductor package according to the one embodiment of the present invention, it is preferred that the step of subjecting the substrate to be processed to processing treatment comprise forming a solder bump on one surface of the substrate to be processed.

According to one embodiment of the present invention, there is provided a support glass substrate for supporting a substrate to be processed, the support glass substrate preferably having a transmittance at a thickness of 1 mm at 254 nm of 5% or more, having an average coefficient of thermal expansion at from 30°C to 380°C of from 30×10⁻⁷/°C to 60×10⁻⁷/°C, having a sheet thickness of less than 5.0 mm, and having a total thickness variation (TTV) of 5 µm or less.

### Brief Description of Drawings

FIG. 1 is a conceptual perspective view for illustrating an example of a laminate of the present invention.
FIGS. 2 are conceptual sectional views for illustrating a manufacturing process for a fan-out type WLP.

### Description of Embodiments

It is preferred that a support glass substrate of the present invention comprise, as a glass composition, in terms of mol%, 50% to 80% of SiO₂, 0% to 25% of Al₂O₃, 5.5% to 20% of B₂O₃, 0% to 5% of Li₂O+Na₂O+K₂O, 0% to 15% of MgO, 1% to 25% of CaO, 0% to 10% of SrO, and 0% to 10% of BaO, and have a molar ratio (MgO+SrO+BaO) /CaO of 1.5 or less. The reasons why the contents of the components are limited as described above are described below. In the descriptions of the contents of the components, the expression "%" represents mol%.

SiO₂ is a main component for forming a glass skeleton. When the content of SiO₂ is too small, vitrification becomes difficult, and a Young's modulus and acid resistance are liable to be reduced. However, when the content of SiO₂ is too large, a viscosity at high temperature is increased, with the result that meltability and formability are liable to be reduced. Besides, a devitrified crystal such as cristobalite is liable to precipitate, and a liquidus temperature is liable to be increased. Accordingly, a lower limit of the content range of SiO₂ is preferably 50% or more or 52% or more, particularly preferably 54% or more, and an upper limit thereof is preferably 80% or less, 72% or less, 68% or less, or 65% or less, particularly preferably 62% or less. When the meltability is prioritized, the upper limit is 64% or less or 62% or less, particularly 60% or less.

Al₂O₃ is a component that forms the glass skeleton and increases the Young's modulus. However, when the content of Al₂O₃ is too large, a crystal such as mullite precipitates, and a liquidus viscosity is liable to be reduced. A lower limit of the content range of Al₂O₃ is preferably 0% or more, 3% or more, 5% or more, 7% or more, or 8% or more, particularly preferably 10% or more, and an upper limit thereof is preferably 25% or less, 20% or less, 18% or less, 16% or less, 15% or less, 14% or less, or 13% or less, particularly preferably 12% or less. When the meltability or the formability is prioritized, the upper limit is 12% or less, particularly 11% or less.

B₂O₃ is a component that improves the meltability and devitrification resistance. However, when the content of B₂O₃ is too large, the Young's modulus is liable to be reduced. Accordingly, a lower limit of the content range of B₂O₃ is preferably 5.5% or more, 6% or more, 7% or more, or 8% or more, particularly preferably 9% or more, and an upper limit thereof is preferably 20% or less, 18% or less, 16% or less, 15% or less, or 14% or less, particularly preferably 12% or less.

Alkali metal oxides (Li₂O, Na₂O, and K₂O) are each a component that improves the meltability. However, when the content of the alkali metal oxides is too large, a coefficient of thermal expansion is significantly increased, and an average coefficient of thermal expansion at from 30°C to 380°C is liable to exceed 60×10⁻⁷/°C. Accordingly, the content of Li₂O+Na₂O+K₂O is preferably from 0% to 5%, from 0% to 4%, from 0% to 3%, from 0% to 2%, from 0% to 1%, or from 0% to 0.5%, particularly preferably from 0% to less than 0.1%.

Li₂O is a component that improves the meltability. However, when the content of the alkali metal oxide is too large, the coefficient of thermal expansion is significantly increased, and the average coefficient of thermal expansion at from 30°C to 380°C is liable to exceed 60×10⁻⁷/°C. Accordingly, the content of Li₂O is preferably from 0% to 1%, or from 0% to 0.5%, particularly preferably from 0% to less than 0.1%.

Na₂O is a component that improves the meltability. However, when the content of the alkali metal oxide is too large, the coefficient of thermal expansion is significantly increased, and the average coefficient of thermal expansion at from 30°C to 380°C is liable to exceed 60×10⁻⁷/°C. Accordingly, the content of Na₂O is preferably from 0% to 5%, from 0% to 4%, from 0% to 3%, from 0% to 2%, from 0% to 1%, or from 0% to 0.5%, particularly preferably from 0% to less than 0.1%.

K₂O is a component that improves the meltability. However, when the content of the alkali metal oxide is too large, the coefficient of thermal expansion is significantly increased, and the average coefficient of thermal expansion at of from 30°C to 380°C is liable to exceed 60×10⁻⁷/°C. Accordingly, the content of K₂O is preferably from 0% to 3%, from 0% to 2%, from 0% to 1%, or from 0% to 0.5%, particularly preferably from 0% to less than 0.1%.

MgO is a component that increases the coefficient of thermal expansion. In addition, MgO is a component that reduces the viscosity at high temperature to improve the meltability. Among alkaline earth metal oxides, MgO is a component that remarkably increases the Young's modulus. However, when the content of MgO is large, the devitrification resistance is liable to be reduced. Accordingly, the content of MgO is preferably from 0% to 15%, from 0.1% to 12%, from 0.5% to 10%, from 1% to 9%, from 1% to 8%, from 1% to 5%, or from 1% to 4%, particularly preferably from 1% to 3%.

CaO is a component that reduces the viscosity at high temperature to remarkably improve the meltability without reducing a strain point. In addition, CaO is a component that increases the Young's modulus and the coefficient of thermal expansion. However, when the content of CaO is too large, a crystal such as anorthite precipitates, and the liquidus viscosity is liable to be reduced. Accordingly, the content of CaO is preferably from 1% to 25%, from 3% to 20%, from 4% to 18%, from 5% to 17%, from 6% to 16%, or from 8% to 16%, particularly preferably from 10% to 16%.

SrO is a component that improves the devitrification resistance and increases the coefficient of thermal expansion, and is also a component that reduces the viscosity at high temperature to improve the meltability. However, when the content of SrO is too large, the glass composition loses its balance, and the devitrification resistance is liable to be reduced. Accordingly, the content of SrO is preferably from 0% to 10%, from 0% to 8%, from 0% to 6%, from 0% to 5%, from 0% to 4%, from 0% to 3%, or from 0% to 2%, particularly preferably from 0% to less than 1%.

BaO is a component that improves the devitrification resistance and the formability of the glass. In addition, BaO has an increasing effect on the coefficient of thermal expansion. However, when the content of BaO is too large, the glass composition loses its balance, and the devitrification resistance is liable to be reduced. Accordingly, the content of BaO is preferably from 0% to 10%, from 0% to 8%, from 0% to 6%, from 0% to 5%, or from 0% to 4%, particularly preferably from 0% to 3%. When improvement in devitrification resistance is prioritized, a suitable lower limit of the content range of BaO is 0.1% or more, 1% or more, or 2% or more, particularly 3% or more.

The molar ratio (MgO+SrO+BaO)/CaO is preferably 1.5 or less, 1.4 or less, 1.3 or less, 1.0 or less, 0.9 or less, from 0.1 to 0.8, from 0.2 to 0.7, or from 0.25 to 0.6, particularly preferably from 0.3 to 0.5. When the molar ratio (MgO+SrO+BaO)/CaO is outside the above-mentioned ranges, it becomes difficult to maintain the Young's modulus, the meltability, and the formability at high levels in the range in which the average coefficient of thermal expansion at from 30°C to 380°C is from 35×10⁻⁷/°C to 60×10⁻⁷/°C.

Other components than the above-mentioned components may be introduced as optional components. From the viewpoint of properly exhibiting the effects of the present invention, the content of the other components than the above-mentioned components is preferably 15% or less or 10% or less, particularly preferably 5% or less in terms of total content.

ZnO is a component that reduces the viscosity at high temperature to remarkably improve the meltability and the formability, and is also a component that improves weather resistance. However, when the content of ZnO is too large, the glass is liable to devitrify. Accordingly, the content of ZnO is preferably from 0% to 3%, from 0% to 2%, or from 0% to 1%, particularly preferably from 0% to 0.1%.

Fe₂O₃ is an impurity component, or is a component that may be introduced as a fining agent component. However, when the content of Fe₂O₃ is too large, an ultraviolet light transmittance may be reduced. That is, when the content of Fe₂O₃ is too large, it becomes difficult to properly perform adhesion and detachment between a substrate to be processed and the support glass substrate through a resin layer and a peeling layer. Accordingly, the content of Fe₂O₃ is preferably from 0% to 0.05%, from 0% to 0.03%, or from 0% to 0.02%, particularly preferably from 0.001% to 0.01%. The term "Fe₂O₃" as used in the present invention includes ferrous oxide and ferric oxide, and ferrous oxide is treated in terms of Fe₂O₃. Other oxides are similarly treated with reference to indicated oxides.

TiO₂ is a component that may be introduced as an impurity component. However, when the content of TiO₂ is too large, the ultraviolet light transmittance may be reduced. That is, when the content of TiO₂ is too large, it becomes difficult to properly perform the adhesion and detachment between the substrate to be processed and the support glass substrate through the resin layer and the peeling layer. Accordingly, the content of TiO₂ is preferably from 0% to 0.05%, from 0% to 0.03%, or from 0% to 0.02%, particularly preferably from 0.001% to 0.01%.

SnO₂ is a component that has a satisfactory fining action in a high-temperature region, and is also a component that reduces the viscosity at high temperature. The content of SnO₂ is preferably from 0% to 2%, from 0.001% to 1%, or from 0.01% to 0.9%, particularly preferably from 0.05% to 0.7%. When the content of SnO₂ is too large, a devitrified crystal of SnO₂ is liable to precipitate. When the content of SnO₂ is too small, it becomes difficult to exhibit the above-mentioned effects.

As₂O₃ and Sb₂O₃ each effectively act as a fining agent, but from an environmental point of view, it is preferred that the content of each of these components be reduced to the extent possible. The content of each of As₂O₃ and Sb₂O₃ is preferably 1% or less, 0.5% or less, or 0.1% or less, particularly preferably 0.05% or less.

SO₃ is a component that has a fining action. The content of SO₃ is preferably from 0% to 1%, from 0% to 0.5%, or from 0% to 0.1%, particularly preferably from 0% to 0.01%. When the content of SO₃ is too large, reboil of SO₂ is liable to occur.

Further, F, C, or metal powder, such as Al or Si, may be introduced as a fining agent up to about 1% as long as the glass characteristics are not impaired. In addition, CeO₂ or the like may also be introduced up to about 1%, but it is required to pay attention to a reduction in ultraviolet light transmittance.

Cl is a component that accelerates the melting of the glass. When Cl is introduced into the glass composition, a reduction in melting temperature and promotion of the fining action can be achieved, with the result that a reduction in melting cost and an increase in lifetime of a glass production kiln are easily achieved. However, when the content of Cl is too large, a metal part around the glass production kiln may be corroded. Accordingly, the content of Cl is preferably 3% or less, 1% or less, or 0.5% or less, particularly preferably 0.1% or less.

P₂O₅ is a component that can suppress precipitation of a devitrified crystal. However, when P₂O₅ is introduced in a large amount, the glass is liable to undergo phase separation. Accordingly, the content of P₂O₅ is preferably from 0% to 15%, from 0% to 2.5%, from 0% to 1.5%, or from 0% to 0.5%, particularly preferably from 0% to 0.3%.

TiO₂ is a component that reduces the viscosity at high temperature to improve the meltability, and is also a component that suppresses solarization. However, when TiO₂ is introduced in a large amount, the glass is colored, and its transmittance is liable to be reduced. Accordingly, the content of TiO₂ is preferably from 0% to 5%, from 0% to 3%, or from 0% to 1%, particularly preferably from 0% to 0.02%.

ZrO₂ is a component that improves chemical resistance and the Young's modulus. However, when ZrO₂ is introduced in a large amount, the glass is liable to devitrify. In addition, a raw material for introducing ZrO₂ has a low solubility, and hence undissolved crystalline foreign matter may be mixed in the glass. Accordingly, the content of ZrO₂ is preferably from 0% to 10%, from 0% to 7%, from 0% to 5%, from 0% to 3%, or from 0% to 1%, particularly preferably from 0% to 0.1%.

Y₂O₃, Nb₂O₅, and La₂O₃ each have an action of increasing the strain point, the Young's modulus, and the like. However, when each of the contents of those components is larger than 5%, particularly 1%, the raw material cost and product cost may be increased.

The support glass substrate of the present invention preferably has the following characteristics.

The average coefficient of thermal expansion within the temperature range of from 30°C to 380°C is preferably from 35×10⁻⁷/°C to 60×10⁻⁷/°C, from 38×10⁻⁷/°C to 55×10⁻⁷/°C, or from 39×10⁻⁷/°C to 52×10⁻⁷/°C, particularly preferably from 40×10⁻⁷/°C to 50×10⁻⁷/°C. When the average coefficient of thermal expansion within the temperature range of from 30°C to 380°C is outside the above-mentioned ranges, it becomes difficult to match the coefficient of thermal expansion with the coefficient of thermal expansion of a semiconductor chip, with the result that a dimensional change (particularly, warping deformation) of a substrate to be processed on the support glass substrate is liable to occur at the time of processing treatment.

The Young's modulus is preferably 70 GPa or more, 73 GPa or more, or 74 GPa or more, particularly preferably 75 GPa or more. When the Young's modulus is too low, it becomes difficult to maintain the stiffness of a laminate, with the result that deformation, warping, breakage, or the like of a substrate to be processed is liable to occur.

A temperature at 10^{2.5} dPa·s is preferably less than 1,600°C, 1,550°C or less, 1,520°C or less, or 1,500°C or less, particularly preferably 1,480°C or less. When the temperature at 10^{2.5} dPa·s is increased, the meltability is reduced, and the manufacturing cost of the glass substrate is increased.

The liquidus viscosity is preferably 10^{4.0} dPa·s or more, 10^{4.6} dPa·s or more, 10^{4.8} dPa·s or more, or 10^{5.0} dPa·s or more, particularly preferably 10^{5.2} dPa·s or more. With this configuration, a devitrified crystal is less liable to precipitate at the time of forming, and hence the glass substrate is easily formed by a down-draw method, particularly an overflow down-draw method.

A transmittance at a thickness of 1 mm at 254 nm is preferably 5% or more, 10% or more, 20% or more, or 25% or more, particularly preferably 30% or more. When the transmittance at a thickness of 1 mm at 254 nm is too low, it becomes difficult to peel a substrate to be processed from the support glass substrate with light at shorter wavelengths after processing treatment of the substrate to be processed.

The support glass substrate of the present invention preferably has the following shape.

The support glass substrate of the present invention preferably has a wafer shape, and the diameter thereof is preferably 100 mm or more and 500 mm or less, particularly preferably 150 mm or more and 450 mm or less. With this configuration, the support glass substrate is easily applied to a manufacturing process for a fan-out type WLP. As required, the support glass substrate may be processed into any other shape, for example, a rectangular shape.

A circularity is preferably 1 mm or less, 0.1 mm or less, or 0.05 mm or less, particularly preferably 0.03 mm or less. As the circularity becomes smaller, the support glass substrate is applied to the manufacturing process for a fan-out type WLP more easily. The "circularity" refers to a value obtained by subtracting the minimum contour value of a wafer from the maximum contour value thereof except for a notch portion.

A sheet thickness is preferably less than 2.0 mm, 1.5 mm or less, 1.2 mm or less, 1.1 mm or less, or 1.0 mm or less, particularly preferably 0.9 mm or less. As the sheet thickness becomes smaller, the mass of the laminate is reduced, and hence the handling property thereof is improved. Meanwhile, when the sheet thickness is excessively small, the strength of the support glass substrate itself decreases, and hence the support glass substrate does not easily function as a supporting substrate. Accordingly, the sheet thickness is preferably 0.1 mm or more, 0.2 mm or more, 0.3 mm or more, 0.4 mm or more, 0.5 mm or more, or 0.6 mm or more, particularly preferably more than 0.7 mm.

A total thickness variation (TTV) is preferably 5 µm or less, 4 µm or less, 3 µm or less, 2 um or less, or 1 µm or less, particularly preferably from 0.1 um to less than 1 um. In addition, an arithmetic average roughness Ra is preferably 20 nm or less, 10 nm or less, 5 nm or less, 2 nm or less, or 1 nm or less, particularly preferably 0.5 nm or less. As surface accuracy becomes higher, the accuracy of the processing treatment is increased more easily. In particular, wiring accuracy can be increased, and hence high-density wiring can be performed. In addition, the strength of the support glass substrate is increased, with the result that the support glass substrate and the laminate are less liable to be broken. Further, the number of times of reuse of the support glass substrate can be increased. The "arithmetic average roughness Ra" may be measured with a stylus-type surface roughness meter or an atomic force microscope (AFM).

It is preferred that the surface of the support glass substrate of the present invention be polished after its formation by the overflow down-draw method. With this configuration, the total thickness variation (TTV) can be easily controlled to less than 2.0 um, 1.5 um or less, or 1.0 um or less, particularly from 0.1 um to less than 1.0 µm.

A warpage level is preferably 60 um or less, 55 um or less, 50 um or less, or from 1 um to 45 µm, particularly preferably from 5 um to 40 um. As the warpage level becomes smaller, the accuracy of the processing treatment is increased more easily. In particular, the wiring accuracy can be increased, and hence high-density wiring can be performed.

The support glass substrate of the present invention preferably has a notch portion (notch-shaped position alignment portion), and the notch portion more preferably has, in a deep portion thereof, a substantially circular shape or a substantially V-groove shape in plan view. This facilitates the position fixation of the support glass substrate by bringing a positioning member such as a positioning pin into abutment with the notch portion of the support glass substrate. As a result, this facilitates position alignment between the support glass substrate and the substrate to be processed. Particularly when a notch portion is also formed in the substrate to be processed, and the positioning member is brought into abutment with the notch portion, the position alignment is facilitated in the entire laminate.

The support glass substrate of the present invention is preferably formed by a down-draw method, particularly an overflow down-draw method. The overflow down-draw method is a method in which molten glass is caused to overflow from both sides of a heat-resistant trough-shaped structure, and the overflowing molten glasses are subjected to down-draw molding downward at the lower end of the trough-shaped structure while being joined, to thereby manufacture a glass substrate. In the overflow down-draw method, surfaces that are to serve as the surfaces of the glass substrate are formed in a state of free surfaces without being brought into contact with a trough-shaped refractory. Accordingly, with slight polishing, the total thickness variation (TTV) can be reduced to less than 2.0 um, particularly to less than 1.0 um. As a result, the manufacturing cost of the glass substrate can be reduced.

It is preferred that the support glass substrate of the present invention be prevented from being subjected to ion exchange treatment and having a compressive stress layer on the surface thereof. When the support glass substrate is subjected to the ion exchange treatment, the manufacturing cost of the support glass substrate rises. However, when the support glass substrate is prevented from being subjected to the ion exchange treatment, the manufacturing cost of the support glass substrate can be reduced. Further, when the support glass substrate is subjected to the ion exchange treatment, it becomes difficult to reduce the total thickness variation (TTV) of the support glass substrate. However, when the support glass substrate is prevented from being subjected to the ion exchange treatment, such inconvenience is easily solved. The support glass substrate of the present invention does not exclude an aspect in which the support glass substrate is subjected to the ion exchange treatment, to thereby form a compressive stress layer on the surface thereof. When attention is paid only to the viewpoint of increasing mechanical strength, it is preferred that the support glass substrate be subjected to the ion exchange treatment, to thereby form a compressive stress layer on the surface thereof.

A laminate of the present invention is a laminate, comprising at least a substrate to be processed and a support glass substrate for supporting the substrate to be processed, wherein the support glass substrate is the above-mentioned support glass substrate. The laminate of the present invention preferably comprises an adhesive layer between the substrate to be processed and the support glass substrate. The adhesive layer is preferably formed of a resin, and for example, a thermosetting resin, a photocurable resin (in particular, a UV-curable resin), and the like are preferred. In addition, the adhesive layer preferably has heat resistance that resists heat treatment in the manufacturing process for a fan-out type WLP. With this configuration, the adhesive layer is less liable to be melted in the manufacturing process for a fan-out type WLP, and the accuracy of the processing treatment can be enhanced. A UV-curable tape may also be used as the adhesive layer in order to fix the substrate to be processed and the support glass substrate easily.

The laminate of the present invention preferably further comprises a peeling layer between the substrate to be processed and the support glass substrate, more specifically between the substrate to be processed and the adhesive layer, or preferably further comprises a peeling layer between the support glass substrate and the adhesive layer. With this configuration, after the substrate to be processed is subjected to predetermined processing treatment, the substrate to be processed is easily peeled from the support glass substrate. From the viewpoint of productivity, it is preferred that the substrate to be processed be peeled from the support glass substrate through use of irradiation light such as UV laser light.

The peeling layer is formed of a material in which "in-layer peeling" or "interfacial peeling" occurs through use of irradiation light such as laser light. That is, the peeling layer is formed of a material in which the interatomic or intermolecular binding force between atoms or molecules is lost or reduced to cause ablation or the like, to thereby cause peeling, through irradiation with light having predetermined intensity. There are the case in which components in the peeling layer turn into a gas to be released, to thereby cause separation, through irradiation with irradiation light, and the case in which the peeling layer absorbs light to turn into a gas and the vapor thereof is released, to thereby cause separation.

In the laminate of the present invention, it is preferred that the support glass substrate be larger than the substrate to be processed. With this configuration, even when the center positions of the substrate to be processed and the support glass substrate are slightly separated from each other at a time when the substrate to be processed and the support glass substrate are supported, an edge portion of the substrate to be processed is less liable to protrude from the support glass substrate.

A method of manufacturing a semiconductor package of the present invention is a method, comprising the steps of: preparing a laminate comprising at least a substrate to be processed and a support glass substrate for supporting the substrate to be processed; and subjecting the substrate to be processed to processing treatment, wherein the support glass substrate is the above-mentioned support glass substrate.

It is preferred that the method of manufacturing a semiconductor package of the present invention further comprise a step of conveying the laminate. With this configuration, the treatment efficiency of the processing treatment can be enhanced. The "step of conveying the laminate" and the "step of subjecting the substrate to be processed to processing treatment" are not required to be performed separately, and may be performed simultaneously.

In the method of manufacturing a semiconductor package of the present invention, it is preferred that the processing treatment be treatment involving arranging wiring on one surface of the substrate to be processed or treatment involving forming solder bumps on one surface of the substrate to be processed. In the method of manufacturing a semiconductor package of the present invention, during the treatment, a dimensional change is less liable to occur in the substrate to be processed, and hence those steps can be performed properly.

Besides the foregoing, the processing treatment may be any of treatment involving mechanically polishing one surface (in general, the surface on an opposite side to the support glass substrate) of the substrate to be processed, treatment involving subjecting one surface (in general, the surface on the opposite side to the support glass substrate) of the substrate to be processed to dry etching, and treatment involving subjecting one surface (in general, the surface on the opposite side to the support glass substrate) of the substrate to be processed to wet etching. In the method of manufacturing a semiconductor package of the present invention, warpage is less liable to occur in the substrate to be processed, and the stiffness of the laminate can be maintained. As a result, the processing treatment can be performed properly.

The present invention is further described with reference to the drawings.

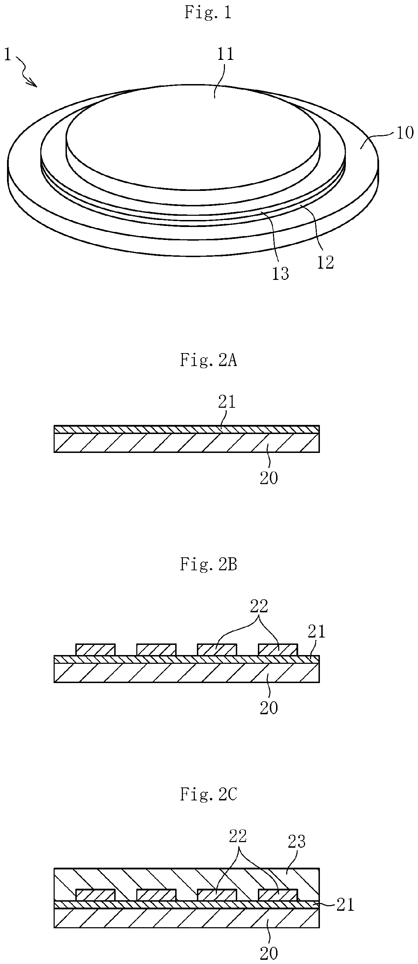

FIG. 1 is a conceptual perspective view for illustrating an example of a laminate 1 of the present invention. In FIG. 1, the laminate 1 comprises a support glass substrate 10 and a substrate 11 to be processed. The support glass substrate 10 is bonded onto the substrate 11 to be processed so as to prevent a dimensional change of the substrate 11 to be processed. A peeling layer 12 and an adhesive layer 13 are arranged between the support glass substrate 10 and the substrate 11 to be processed. The peeling layer 12 is held in contact with the support glass substrate 10, and the adhesive layer 13 is held in contact with the substrate 11 to be processed.

That is, the laminate 1 comprises the support glass substrate 10, the peeling layer 12, the adhesive layer 13, and the substrate 11 to be processed, which are laminated and arranged in the stated order. The shape of the support glass substrate 10 is determined depending on the substrate 11 to be processed, and in FIG. 1, both the support glass substrate 10 and the substrate 11 to be processed have substantially disc shapes. For example, a resin degradable by laser irradiation may be used for the peeling layer 12. In addition, a substance that absorbs laser light efficiently and converts the light into heat may also be added to the resin. For example, carbon black, graphite powder, fine-particle metal powder, a dye, a pigment, or the like may also be added to the resin. The peeling layer 12 is formed by plasma CVD, spin coating using a sol-gel method, or the like. The adhesive layer 13 is made of a resin and is formed through application, for example, by any of various printing methods, an ink jet method, a spin coating method, a roll coating method, or the like. In addition, a UV-curable tape may also be used. The adhesive layer 13 is removed by being dissolved in a solvent or the like after the support glass substrate 10 is peeled from the substrate 11 to be processed through use of the peeling layer 12. The UV-curable tape may be removed with a peeling tape after UV irradiation.

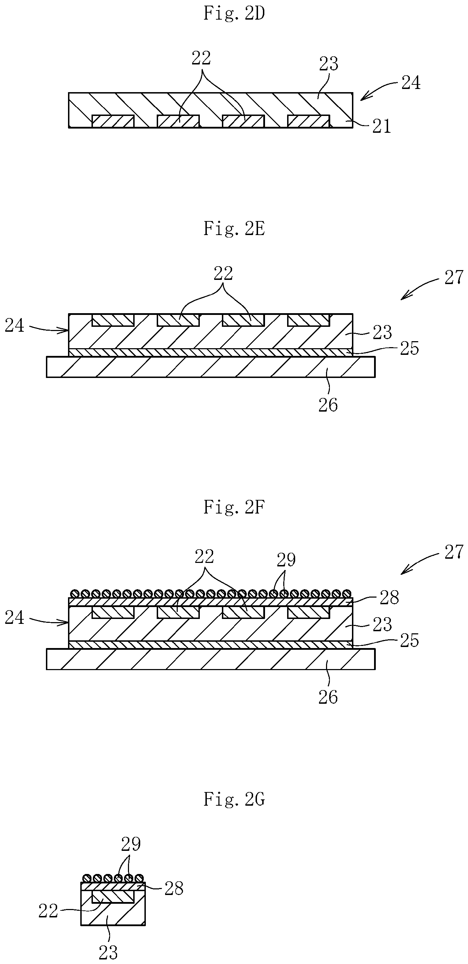

FIGS. 2 are conceptual sectional views for illustrating a manufacturing process for a fan-out type WLP. FIG. 2(a) is an illustration of a state in which an adhesive layer 21 is formed on one surface of a supporting member 20. As required, a peeling layer may be formed between the supporting member 20 and the adhesive layer 21. Next, as illustrated in FIG. 2(b), a plurality of semiconductor chips 22 are bonded onto the adhesive layer 21. In this case, an active surface of each semiconductor chip 22 is brought into contact with the adhesive layer 21. Then, as illustrated in FIG. 2(c), the semiconductor chips 22 are molded with a sealing material 23 of a resin. As the sealing material 23, a material having less dimensional change after compression molding and having less dimensional change during formation of wiring is used. Subsequently, as illustrated in FIG. 2(d) and FIG. 2(e), a substrate 24 to be processed having the semiconductor chips 22 molded therein is separated from the supporting member 20 and is then adhesively fixed onto a support glass substrate 26 via an adhesive layer 25. In this case, in the surface of the substrate 24 to be processed, the surface on an opposite side to the surface in which the semiconductor chips 22 are buried is arranged on the support glass substrate 26 side. Thus, a laminate 27 can be obtained. As required, a peeling layer may be formed between the adhesive layer 25 and the support glass substrate 26. Further, after the obtained laminate 27 is conveyed, as illustrated in FIG. 2(f), a wiring 28 is formed on the surface of the substrate 24 to be processed in which the semiconductor chips 22 are buried, and then a plurality of solder bumps 29 are formed. Finally, after the substrate 24 to be processed is separated from the support glass substrate 26, the substrate 24 to be processed is cut for each semiconductor chip 22 to be used in a later packaging step (FIG. 2(g)).

### Example 1

Now, the present invention is described by way of Examples. However, Examples below are merely examples, and the present invention is by no means limited to the following Examples.

Examples (Sample Nos. 1 to 69) of the present invention are shown in Tables 1 to 7.

**Table 1**

| mol% | No. 1 | No. 2 | No. 3 | No. 4 | No. 5 | No. 6 | No. 7 | No. 8 | No. 9 | No. 10 |
|---|---|---|---|---|---|---|---|---|---|---|
| SiO₂ | 56.8 | 63.5 | 57.9 | 55.2 | 54.5 | 55.7 | 57.5 | 67.3 | 63.9 | 58.2 |
| Al₂O₃ | 15.0 | 15.1 | 14.9 | 12.2 | 14.8 | 11.0 | 13.6 | 10.9 | 11.0 | 10.9 |
| B₂O₃ | 12.2 | 9.1 | 9.2 | 7.6 | 7.3 | 9.3 | 5.8 | 8.8 | 8.9 | 8.9 |
| Li₂O | 0.0 | 0.0 | 0.0 | 0.0 | 0.0 | 0.0 | 0.0 | 0.0 | 0.0 | 0.0 |
| Na₂O | 0.000 | 0.000 | 0.000 | 0.000 | 0.000 | 0.000 | 0.000 | 0.022 | 0.022 | 0.011 |
| K₂O | 0.000 | 0.000 | 0.000 | 0.000 | 0.000 | 0.001 | 0.001 | 0.002 | 0.003 | 0.001 |
| MgO | 3.0 | 0.0 | 0.1 | 11.2 | 6.2 | 11.0 | 6.2 | 0.0 | 0.1 | 0.1 |
| CaO | 12.9 | 12.1 | 17.8 | 13.7 | 17.1 | 12.9 | 16.8 | 9.9 | 13.1 | 18.9 |
| SrO | 0.0 | 0.0 | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 3.0 | 3.0 | 2.9 |
| SnO₂ | 0.1 | 0.1 | 0.1 | 0.1 | 0.1 | 0.1 | 0.1 | 0.1 | 0.1 | 0.1 |
| Fe₂O₃ | 0.0050 | 0.0042 | 0.0050 | 0.0075 | 0.0069 | 0.0071 | 0.0065 | 0.0021 | 0.0030 | 0.0038 |
| TiO₂ | 0.002 | 0.002 | 0.002 | 0.002 | 0.002 | 0.002 | 0.002 | 0.003 | 0.006 | 0.007 |
| Li₂O+Na₂O+K₂O | 0.000 | 0.000 | 0.000 | 0.000 | 0.000 | 0.001 | 0.001 | 0.024 | 0.025 | 0.012 |
| (MgO+SrO+BaO)/CaO | 0.23 | 0.00 | 0.01 | 0.82 | 0.36 | 0.85 | 0.37 | 0.30 | 0.23 | 0.16 |
| ρ (g/cm³) | Unmeas ured | Unmeas ured | Unmeas ured | Unmeas ured | Unmeas ured | 2.54 | 2.57 | 2.50 | 2.55 | 2.64 |
| CTE₃₀₋₃₈₀ (×10⁻⁷/°C) | 40 | 36 | 44 | 48 | 48 | 48 | 48 | 39 | 44 | 52 |
| Tg (°C) | 724 | 762 | 744 | 707 | 718 | 692 | 727 | Unmeas ured | Unmeas ured | Unmeas ured |
| Tf (°C) | 774 | 806 | 796 | 757 | 774 | 741 | 776 | 774 | 772 | 751 |
| E (GPa) | 77 | 78 | 80 | 87 | 87 | 85 | 87 | 72 | 75 | 80 |
| Ps (°C) | Unmeas ured | 705 | 690 | 670 | 680 | 656 | 684 | 668 | 662 | 656 |
| Ta (°C) | Unmeas ured | 761 | 739 | 716 | 728 | 701 | 732 | 724 | 712 | 700 |
| Ts (°C) | Unmeas ured | 980 | 934 | 900 | 910 | 882 | 918 | 962 | 926 | 879 |
| 10^{4.0} dPa·s (°C) | Unmeas ured | 1,271 | 1,193 | 1,126 | 1,136 | 1,107 | 1,154 | 1,286 | 1,228 | 1,119 |
| 10^{3.0} dPa·s (°C) | Unmeas ured | 1,416 | 1,326 | 1,248 | 1,255 | 1,229 | 1,279 | 1,454 | 1,388 | 1,253 |
| 10^{2.5} dPa·s (°C) | Unmeas ured | 1, 510 | 1,413 | 1,327 | 1,332 | 1,308 | 1,360 | 1,561 | 1,489 | 1,341 |
| 10^{2.0} dPa·s (°C) | Unmeas ured | 1, 624 | 1,520 | 1,426 | 1,429 | 1,408 | 1,462 | 1, 688 | 1,614 | 1,450 |
| TL (°C) | Unmeas ured | Unmeas ured | >1,331 | 1,132 | 1,182 | Unmeas ured | Unmeas ured | 1,090 | 1,076 | 1,049 |
| logη (°C) | Unmeas ured | Unmeas ured | <3.0 | 3.9 | 3.6 | Unmeas ured | Unmeas ured | 5.8 | 5.4 | 4.8 |
| T254nm (%) | 13 | 14 | 10 | 5 | 5 | 5 | 5 | 10 | 9 | 8 |

**Table 2**

| mol% | No. 11 | No. 12 | No. 13 | No. 14 | No. 15 | No. 16 | No. 17 | No. 18 | No. 19 | No. 20 |
|---|---|---|---|---|---|---|---|---|---|---|
| SiO₂ | 68.1 | 62.0 | 56.3 | 61.0 | 61.0 | 63.5 | 64.2 | 67.2 | 61.7 | 61.9 |
| Al₂O₃ | 10.9 | 10.9 | 10.8 | 10.9 | 11.0 | 10.3 | 11.0 | 10.9 | 10.9 | 10.9 |
| B₂O₃ | 8.9 | 8.9 | 9.0 | 8.9 | 9.0 | 7.9 | 8.8 | 8.9 | 9.3 | 9.2 |
| Li₂O | 0.0 | 0.0 | 0.0 | 0.0 | 0.0 | 0.0 | 0.0 | 0.0 | 0.0 | 0.0 |
| Na₂O | 0.023 | 0.022 | 0.000 | 0.011 | 0.011 | 0.000 | 0.000 | 0.000 | 0.000 | 0.000 |
| K₂O | 0.001 | 0.001 | 0.000 | 0.001 | 0.001 | 0.001 | 0.002 | 0.002 | 0.001 | 0.001 |
| MgO | 0.0 | 0.1 | 0.1 | 0.2 | 0.1 | 3.6 | 5.9 | 2.9 | 0.1 | 2.9 |
| CaO | 7.0 | 13.0 | 18.8 | 16.0 | 15.8 | 8.9 | 7.0 | 7.0 | 14.0 | 11.0 |
| SrO | 0.0 | 0.0 | 0.0 | 0.0 | 3.0 | 4.9 | 0.0 | 0.0 | 0.0 | 0.0 |
| BaO | 4.9 | 5.0 | 4.9 | 3.0 | 0.0 | 0.9 | 3.0 | 3.0 | 4.0 | 3.9 |
| SnO₂ | 0.1 | 0.1 | 0.1 | 0.1 | 0.1 | 0.1 | 0.1 | 0.1 | 0.1 | 0.1 |
| Fe₂O₃ | 0.0018 | 0.0031 | 0.0039 | 0.0008 | 0.0037 | 0.0038 | 0.0038 | 0.0025 | 0.0004 | 0.0017 |
| TiO₂ | 0.004 | 0.003 | 0.003 | 0.002 | 0.005 | 0.002 | 0.002 | 0.002 | 0.002 | 0.002 |
| Li₂O+Na₂O+K₂O | 0.024 | 0.023 | 0.000 | 0.012 | 0.011 | 0.001 | 0.002 | 0.002 | 0.001 | 0.001 |
| (MgO+SrO+BaO)/CaO | 0.71 | 0.39 | 0.27 | 0.20 | 0.20 | 1.06 | 1.27 | 0.85 | 0.29 | 0.63 |
| ρ (g/cm³) | 2.54 | 2.64 | 2.73 | 2.60 | 2.56 | 2.58 | 2.52 | 2.48 | 2.61 | 2.59 |
| CTE₃₀₋₃₈₀ (×10⁻⁷/°C) | 39 | 47 | 56 | 48 | 47 | 44 | 38 | 37 | 47 | 44 |
| Tg (°C) | Unmeas ured | Unmeas ured | Unmeas ured | Unmeas ured | Unmeas ured | 714 | 719 | 731 | 709 | 707 |
| Tf (°C) | 787 | 764 | 727 | 753 | 758 | 714 | 778 | 793 | 768 | 770 |
| E (GPa) | 70 | 76 | 81 | 78 | 79 | 78 | 76 | 74 | 77 | 77 |
| Ps (°C) | 666 | 655 | 648 | 658 | 662 | 662 | 665 | 670 | 656 | 655 |
| Ta (°C) | 726 | 703 | 690 | 704 | 709 | 711 | 717 | 727 | 704 | 704 |
| Ts (°C) | 978 | 903 | 862 | 897 | 902 | 922 | 940 | 967 | 904 | 911 |
| 10^{4.0} dPa·s (°C) | 1,314 | 1, 188 | 1,097 | 1,163 | 1,169 | 1,215 | 1,242 | 1,259 | 1, 187 | 1,198 |
| 10^{3.0} dPa·s (°C) | 1,485 | 1,341 | 1,225 | 1,309 | 1,314 | 1,369 | 1,398 | 1,421 | 1,338 | 1,351 |
| 10^{2.5} dPa·s (°C) | 1,594 | 1,440 | 1,310 | 1,404 | 1,409 | 1,470 | 1,498 | 1,525 | 1,436 | 1,448 |
| 10^{2.0} dPa·s (°C) | 1,723 | 1,563 | 1,416 | 1,521 | 1,524 | 1,592 | 1,621 | 1,644 | 1,566 | 1,572 |
| TL (°C) | <951 | 1,065 | 1,042 | 1,042 | 1,113 | Unmeas ured | 1,095 | 1, 098 | 1,054 | 1,044 |
| logη (°C) | >8.1 | 5.2 | 4.6 | 5.3 | 4.5 | Unmeas ured | 5.4 | 5.6 | 5.3 | 5.6 |
| T254nm (%) | 12 | 13 | 13 | 24 | 12 | 12 | 10 | 10 | 27 | 20 |

**Table 3**

| mol% | No. 21 | No. 22 | No. 23 | No. 24 | No. 25 | No. 26 | No. 27 | No. 28 | No. 29 | No. 30 |
|---|---|---|---|---|---|---|---|---|---|---|
| SiO₂ | 62.0 | 65.6 | 66.9 | 59.7 | 64.9 | 57.6 | 58.1 | 58.0 | 65.1 | 55.9 |
| Al₂O₃ | 11.0 | 11.0 | 11.1 | 10.9 | 13.0 | 12.9 | 11.0 | 10.9 | 11.1 | 10.9 |
| B₂O₃ | 9.0 | 8.8 | 7.1 | 7.2 | 7.2 | 7.2 | 9.0 | 9.1 | 9.0 | 9.3 |
| Li₂O | 0.0 | 0.0 | 0.0 | 0.0 | 0.0 | 0.0 | 0.0 | 0.0 | 0.0 | 0.0 |
| Na₂O | 0.000 | 0.000 | 0.000 | 0.000 | 0.000 | 0.000 | 0.000 | 0.000 | 0.000 | 0.000 |
| K₂O | 0.003 | 0.001 | 0.001 | 0.000 | 0.001 | 0.000 | 0.000 | 0.000 | 0.002 | 0.000 |
| MgO | 5.9 | 0.1 | 0.1 | 0.2 | 0.1 | 0.1 | 2.0 | 2.0 | 2.0 | 3.9 |
| CaO | 8.1 | 11.4 | 11.7 | 19.0 | 11.7 | 19.1 | 16.9 | 15.0 | 7.6 | 14.8 |
| SrO | 0.0 | 0.0 | 0.0 | 0.0 | 0.0 | 0.0 | 0.0 | 2.0 | 3.0 | 3.0 |
| BaO | 4.0 | 3.0 | 3.0 | 3.0 | 3.0 | 3.0 | 3.0 | 3.0 | 2.0 | 2.0 |
| SnO₂ | 0.1 | 0.1 | 0.1 | 0.1 | 0.1 | 0.1 | 0.1 | 0.1 | 0.1 | 0.1 |
| Fe₂O₃ | 0.0025 | 0.0004 | 0.0009 | 0.0008 | 0.0009 | 0.0009 | 0.0013 | 0.0017 | 0.0017 | 0.0004 |
| TiO₂ | 0.002 | 0.002 | 0.002 | 0.002 | 0.002 | 0.001 | 0.001 | 0.002 | 0.001 | 0.001 |
| Li₂O+Na₂O+K₂O | 0.003 | 0.001 | 0.001 | 0.000 | 0.001 | 0.000 | 0.000 | 0.000 | 0.002 | 0.000 |
| (MgO+SrO+BaO)/CaO | 1.23 | 0.27 | 0.26 | 0.16 | 0.27 | 0.16 | 0.29 | 0.46 | 0.93 | 0.60 |
| ρ (g/cm³) | 2.58 | 2.52 | 2.53 | 2.65 | 2.54 | 2.66 | 2.64 | 2.67 | 2.53 | 2.67 |
| CTE₃₀₋₃₈₀ (×10⁻⁷/°C) | 42 | 41 | 41 | 51 | 41 | 51 | 51 | 51 | 40 | 52 |
| Tg (°C) | 711 | 724 | 738 | 714 | 756 | 723 | 697 | 700 | 720 | 602 |
| Tf (°C) | 767 | 784 | 800 | 763 | 817 | 778 | 744 | 751 | 782 | 746 |
| E (GPa) | 77 | 74 | 75 | 81 | 76 | 82 | 81 | 81 | 75 | 82 |
| Ps (°C) | 657 | 666 | 679 | 663 | 693 | 670 | 652 | 651 | 662 | 645 |
| Ta (°C) | 707 | 720 | 734 | 709 | 750 | 717 | 697 | 695 | 716 | 688 |
| Ts (°C) | 918 | 946 | 963 | 893 | 976 | 904 | 880 | 879 | 945 | 866 |
| 10^{4.0} dPa·s (°C) | 1,209 | 1,259 | 1,283 | 1,145 | 1,282 | 1,152 | 1,127 | 1,129 | 1,259 | 1,107 |
| 10^{3.0} dPa·s (°C) | 1,361 | 1,423 | 1,450 | 1,283 | 1,442 | 1,285 | 1,262 | 1,264 | 1,423 | 1,235 |
| 10^{2.5} dPa·s (°C) | 1,458 | 1,529 | 1,560 | 1,374 | 1,549 | 1,372 | 1,350 | 1,353 | 1,528 | 1,320 |
| 10^{2.0} dPa·s (°C) | 1,589 | 1,654 | 1,694 | 1,486 | 1,683 | 1,480 | 1,461 | 1,464 | 1,653 | 1,425 |
| TL (°C) | 1,051 | 1,094 | 1,141 | 1,094 | >1,231 | >1,256 | 1,056 | 1,048 | Unmeas ured | 1,073 |
| logη (°C) | 5.6 | 5.5 | 5.2 | 4.5 | <4.4 | <3.1 | 4.8 | 4.9 | Unmeas ured | 4.2 |
| T254nm (%) | 13 | 21 | 21 | 36 | 18 | 25 | 28 | 22 | 18 | 40 |

**Table 4**

| mol% | No. 31 | No. 32 | No. 33 | No. 34 | No. 35 | No. 36 | No. 37 | No. 38 | No. 39 | No. 40 |
|---|---|---|---|---|---|---|---|---|---|---|
| SiO₂ | 56.9 | 53.9 | 55.9 | 61.8 | 55.3 | 60.9 | 54.5 | 57.1 | 63.9 | 58.9 |
| Al₂O₃ | 10.9 | 11.0 | 10.9 | 11.0 | 11.0 | 12.0 | 11.9 | 10.9 | 11.0 | 10.9 |
| B₂O₃ | 9.2 | 9.3 | 9.2 | 9.2 | 9.3 | 10.1 | 10.3 | 9.1 | 9.0 | 9.1 |
| Li₂O | 0.0 | 0.0 | 0.0 | 0.0 | 0.0 | 0.0 | 0.0 | 0.0 | 0.0 | 0.0 |
| Na₂O | 0.033 | 0.000 | 0.033 | 0.011 | 0.011 | 0.033 | 0.032 | 0.027 | 0.028 | 0.032 |
| K₂O | 0.000 | 0.000 | 0.000 | 0.001 | 0.001 | 0.000 | 0.000 | 0.000 | 0.000 | 0.000 |
| MgO | 3.9 | 5.9 | 5.9 | 5.9 | 5.9 | 3.8 | 3.8 | 2.9 | 2.9 | 0.0 |
| CaO | 12.9 | 14.7 | 11.9 | 9.0 | 15.4 | 10.0 | 16.4 | 16.9 | 10.0 | 16.9 |
| SrO | 3.0 | 3.0 | 3.0 | 0.0 | 0.0 | 0.0 | 0.0 | 0.0 | 0.0 | 0.5 |
| BaO | 3.0 | 2.0 | 3.0 | 3.0 | 3.0 | 3.0 | 3.0 | 3.0 | 3.0 | 3.5 |
| SnO₂ | 0.1 | 0.1 | 0.1 | 0.1 | 0.1 | 0.1 | 0.1 | 0.1 | 0.1 | 0.1 |
| Fe₂O₃ | 0.0004 | 0.0004 | 0.0009 | 0.0000 | 0.0000 | 0.0002 | 0.0001 | 0.0001 | 0.0002 | 0.0003 |
| TiO₂ | 0.002 | 0.002 | 0.002 | 0.001 | 0.002 | 0.000 | 0.000 | 0.000 | 0.000 | 0.000 |
| Li₂O+Na₂O+K₂O | 0.033 | 0.000 | 0.033 | 0.011 | 0.012 | 0.033 | 0.032 | 0.027 | 0.028 | 0.032 |
| (MgO+SrO+BaO)/CaO | 0.76 | 0.74 | 0.99 | 0.98 | 0.57 | 0.68 | 0.41 | 0.35 | 0.59 | 0.23 |
| ρ (g/cm³) | 2.68 | 2.69 | 2.69 | 2.55 | 2.65 | 2.54 | 2.64 | 2.64 | 2.53 | 2.65 |
| CTE₃₀₋₃₈₀ (×10⁻⁷/°C) | 51 | 54 | 52 | 41 | 51 | 41 | 50 | 51 | 41 | 51 |
| Tg (°C) | 686 | 691 | 688 | 708 | 695 | 702 | 695 | 699 | 707 | 696 |
| Tf (°C) | 739 | 743 | 738 | 764 | 748 | 759 | 751 | 753 | 761 | 746 |
| E (GPa) | 81 | 83 | 81 | 78 | 83 | 77 | 82 | 76 | 82 | 80 |
| Ps (°C) | 644 | 642 | 643 | 654 | 645 | 653 | 646 | 648 | 658 | 652 |
| Ta (°C) | 688 | 685 | 687 | 705 | 689 | 704 | 689 | 693 | 711 | 697 |
| Ts (°C) | 871 | 857 | 868 | 916 | 867 | 915 | 866 | 874 | 931 | 881 |
| 10^{4.0} dPa·s (°C) | 1,122 | 1,089 | 1,116 | 1,206 | 1,109 | 1,207 | 1,109 | 1,124 | 1,236 | 1,143 |
| 10^{3.0} dPa·s (°C) | 1,255 | 1,210 | 1,244 | 1,356 | 1,235 | 1,355 | 1,234 | 1,255 | 1,395 | 1,282 |
| 10^{2.5} dPa·s (°C) | 1,342 | 1,289 | 1, 329 | 1,452 | 1,318 | 1,452 | 1,318 | 1,343 | 1,498 | 1,374 |
| 10^{2.0} dPa·s (°C) | 1,451 | 1,391 | 1,436 | 1,580 | 1,422 | 1,575 | 1,422 | 1,447 | 1, 645 | 1,488 |
| TL (°C) | 1,045 | 1,079 | 1,070 | 1, 087 | 1,064 | 1,064 | >1,149 | 1,075 | 1,094 | 1,058 |
| logη (°C) | 4.8 | 3.8 | 4.3 | 5.1 | 4.2 | 5.4 | <3.6 | 4.5 | 5.3 | 4.9 |
| T254nm (%) | 42 | 41 | 38 | 33 | 43 | 34 | 40 | 50 | 33 | 51 |

**Table 5**

| mol% | No. 41 | No. 42 | No. 43 | No. 44 | No. 45 | No. 46 | No. 47 | No. 48 | No. 49 | No. 50 |
|---|---|---|---|---|---|---|---|---|---|---|
| SiO₂ | 57.1 | 65.2 | 64.2 | 64.5 | 65.2 | 64.6 | 64.3 | 64.0 | 63.7 | 57.2 |
| Al₂O₃ | 11.0 | 10.9 | 10.9 | 11.0 | 11.0 | 11.0 | 11.0 | 11.0 | 11.0 | 10.9 |
| B₂O₃ | 9.6 | 9.0 | 8.9 | 8.9 | 8.8 | 8.9 | 8.9 | 8.9 | 8.9 | 9.0 |
| Li₂O | 0.0 | 0.0 | 0.0 | 0.0 | 0.0 | 0.0 | 0.0 | 0.0 | 0.0 | 0.0 |
| Na₂O | 0.042 | 0.022 | 0.022 | 0.022 | 0.022 | 0.022 | 0.022 | 0.022 | 0.022 | 0.027 |
| K₂O | 0.000 | 0.000 | 0.001 | 0.001 | 0.001 | 0.003 | 0.001 | 0.001 | 0.001 | 0.000 |
| MgO | 2.9 | 0.0 | 1.9 | 1.9 | 1.0 | 1.0 | 1.9 | 1.9 | 1.9 | 0.9 |
| CaO | 14.4 | 11.8 | 10.9 | 10.5 | 11.0 | 11.5 | 10.8 | 11.1 | 11.4 | 18.9 |
| SrO | 1.9 | 0.0 | 0.0 | 0.0 | 0.0 | 0.0 | 0.0 | 0.0 | 0.0 | 0.0 |
| BaO | 3.0 | 3.0 | 3.0 | 3.0 | 3.0 | 3.0 | 3.0 | 3.0 | 3.0 | 3.0 |
| SnO₂ | 0.1 | 0.1 | 0.1 | 0.1 | 0.1 | 0.1 | 0.1 | 0.1 | 0.1 | 0.1 |
| Fe₂O₃ | 0.0003 | 0.0002 | 0.0002 | 0.0002 | 0.0021 | 0.0003 | 0.0003 | 0.0002 | 0.0002 | 0.0001 |
| TiO₂ | 0.000 | 0.001 | 0.000 | 0.000 | 0.002 | 0.000 | 0.000 | 0.000 | 0.000 | 0.000 |
| Li₂O+Na₂O+K₂O | 0.042 | 0.022 | 0.023 | 0.023 | 0.023 | 0.025 | 0.023 | 0.022 | 0.023 | 0.027 |
| (MgO+SrO+BaO)/CaO | 0.54 | 0.25 | 0.45 | 0.47 | 0.36 | 0.34 | 0.45 | 0.44 | 0.43 | 0.20 |
| ρ (g/cm³) | 2.67 | 2.53 | 2.54 | 2.53 | 2.53 | 2.54 | 2.54 | 2.54 | 2.55 | 2.65 |
| CTE₃₀₋₃₈₀ (×10⁻⁷/°C) | 51 | 42 | 42 | 41 | 41 | 42 | 42 | 42 | 42 | 52 |
| Tg (°C) | 694 | 717 | 707 | 715 | 710 | 715 | 704 | 713 | 712 | 694 |
| Tf (°C) | 748 | 781 | 766 | 780 | 770 | 779 | 767 | 778 | 777 | 748 |
| E (GPa) | 81 | 75 | 76 | 76 | 75 | 76 | 76 | 76 | 77 | 83 |
| Ps (°C) | 646 | 661 | 659 | 659 | 662 | 660 | 658 | 658 | 658 | 650 |
| Ta (°C) | 690 | 713 | 711 | 712 | 716 | 712 | 711 | 710 | 710 | 693 |
| Ts (°C) | 872 | 937.5 | 930.5 | 935 | 941 | 933 | 932 | 929.5 | 927 | 872 |
| 10^{4.0} dPa·s (°C) | 1,126 | 1,242 | 1,230 | 1,239 | 1,244 | 1,236 | 1,238 | 1,222 | 1,223 | 1,117 |
| 10^{3.0} dPa·s (°C) | 1,260 | 1,403 | 1,387 | 1,398 | 1,404 | 1,395 | 1,401 | 1,378 | 1,377 | 1,247 |
| 10^{2.5} dPa·s (°C) | 1,348 | 1,505 | 1,487 | 1,509 | 1,506 | 1,496 | 1,503 | 1,477 | 1,477 | 1,334 |
| 10^{2.0} dPa·s (°C) | 1,456 | 1,638 | 1,611 | 1,662 | 1,640 | 1,625 | 1, 629 | 1,608 | 1,602 | 1,441 |
| TL (°C) | 1,055 | 1,101 | 1,101 | 1,090 | 1,080 | 1, 098 | 1,099 | 1, 078 | 1,088 | 1,085 |
| logη (°C) | 4.7 | 5.3 | 5.2 | 5.4 | 5.6 | 5.3 | 5.3 | 5.4 | 5.3 | 4.3 |
| T254nm (%) | 42 | 36 | 36 | 38 | 39 | 36 | 34 | 36 | 34 | 47 |

**Table 6**

| mol% | No. 51 | No. 52 | No. 53 | No. 54 | No. 55 | No. 56 | No. 57 | No. 58 | No. 59 | No. 60 |
|---|---|---|---|---|---|---|---|---|---|---|
| SiO₂ | 57.1 | 57.6 | 57.0 | 62.4 | 61.2 | 60.8 | 60.1 | 62.1 | 61.3 | 60.4 |
| Al₂O₃ | 8.0 | 11.0 | 9.9 | 10.9 | 11.0 | 9.9 | 9.9 | 13.0 | 11.0 | 10.9 |
| B₂O₃ | 11.7 | 8.9 | 9.9 | 8.8 | 9.0 | 10.1 | 9.9 | 8.9 | 8.9 | 8.9 |
| Li₂O | 0.0 | 0.0 | 0.0 | 0.0 | 0.0 | 0.0 | 0.0 | 0.0 | 0.0 | 0.0 |
| Na₂O | 0.027 | 0.035 | 0.031 | 0.029 | 0.029 | 0.024 | 0.030 | 0.044 | 0.037 | 0.030 |
| K₂O | 0.000 | 0.000 | 0.001 | 0.000 | 0.000 | 0.000 | 0.000 | 0.003 | 0.003 | 0.000 |
| MgO | 1.8 | 1.8 | 1.8 | 1.8 | 1.8 | 1.8 | 1.8 | 1.8 | 7.6 | 1.9 |
| CaO | 18.3 | 16.9 | 17.5 | 13.0 | 13.8 | 13.4 | 14.4 | 11.2 | 8.1 | 14.9 |
| SrO | 0.0 | 0.0 | 0.0 | 0.0 | 0.0 | 0.0 | 0.0 | 0.0 | 0.0 | 0.0 |
| BaO | 3.0 | 3.8 | 3.7 | 2.9 | 3.0 | 3.7 | 3.7 | 3.0 | 3.0 | 2.9 |
| SnO₂ | 0.1 | 0.1 | 0.1 | 0.1 | 0.1 | 0.1 | 0.1 | 0.1 | 0.1 | 0.1 |
| Fe₂O₃ | 0.0002 | 0.0002 | 0.0002 | 0.0002 | 0.0002 | 0.0002 | 0.0002 | 0.0002 | 0.0002 | 0.0002 |
| TiO₂ | 0.000 | 0.000 | 0.000 | 0.000 | 0.000 | 0.000 | 0.000 | 0.000 | 0.000 | 0.000 |
| Li₂O+Na₂O+K₂O | 0.027 | 0.035 | 0.031 | 0.029 | 0.029 | 0.024 | 0.030 | 0.047 | 0.039 | 0.030 |
| (MgO+SrO+BaO)/Ca O | 0.26 | 0.33 | 0.32 | 0.36 | 0.35 | 0.41 | 0.38 | 0.43 | 1.30 | 0.32 |
| ρ (g/cm³) | 2.64 | 2.67 | 2.67 | 2.57 | 2.58 | 2.61 | 2.62 | 2.55 | 2.55 | 2.60 |
| CTE₃₀₋₃₈₀ (×10^{- 7}/°C) | 53 | 51 | 52 | 44 | 45 | 47 | 48 | 41 | 41 | 47 |
| Tg (°C) | 675 | 695 | 688 | 704 | 697 | 691 | 684 | 718 | 703 | 698 |
| Tf (°C) | 732 | 750 | 740 | 766 | 755 | 753 | 739 | 772 | 766 | 753 |
| E (GPa) | 82 | 82 | 82 | 79 | 79 | 79 | 79 | 77 | 79 | |
| Ps (°C) | 634 | 648 | 642 | 656 | 652 | 644 | 644 | 669 | 656 | 655 |
| Ta (°C) | 674 | 692 | 684 | 705 | 700 | 690 | 689 | 723 | 706 | 701 |
| Ts (°C) | - | 874 | 858 | 912 | 901 | 884 | 877 | 942 | 916 | 896 |
| 10^{4.0} dPa·s (°C) | 1,068 | 1,124 | 1,100 | 1,205 | 1,185 | 1,159 | 1,146 | 1,233 | 1,188 | 1,165 |
| 10^{3.0} dPa·s (°C) | 1,191 | 1,258 | 1,229 | 1,353 | 1,333 | 1,306 | 1,289 | 1,384 | 1,332 | 1,310 |
| 10^{2.5} dPa·s (°C) | 1,275 | 1,344 | 1,314 | 1,450 | 1,432 | 1,403 | 1,384 | 1,486 | 1,424 | 1,404 |
| 10^{2.0} dPa·s (°C) | 1,380 | 1,453 | 1,422 | 1,573 | 1,552 | 1,522 | 1,500 | 1,613 | 1,545 | 1,522 |
| TL (°C) | 1,065 | 1,061 | 994 | 1, 084 | 1,065 | 1,056 | 1,050 | 1,166 | 1,082 | 1,083 |
| logη (°C) | 4.0 | 4.7 | 5.2 | 5.1 | 5.2 | 5.0 | 5.0 | 4.6 | 5.1 | 4.8 |
| T254nm (%) | 43 | 47 | 47 | 48 | 41 | 48 | 50 | 33 | 39 | 53 |

**Table 7**

| mol% | No. 61 | No. 62 | No. 63 | No. 64 | No. 65 | No. 66 | No. 67 | No. 68 | No. 69 |
|---|---|---|---|---|---|---|---|---|---|
| SiO₂ | 60.6 | 60.4 | 58.5 | 59.3 | 59.5 | 59.8 | 58.8 | 60.1 | 59.0 |
| Al₂O₃ | 11.0 | 10.9 | 10.3 | 10.4 | 10.2 | 10.9 | 10.9 | 9.9 | 9.9 |
| B₂O₃ | 8.9 | 8.9 | 12.6 | 12.3 | 12.4 | 10.2 | 10.2 | 11.0 | 11.1 |
| Li₂O | 0.0 | 0.0 | 0.0 | 0.0 | 0.0 | 0.0 | 0.0 | 0.0 | 0.0 |
| Na₂O | 0.025 | 0.024 | 0.025 | 0.024 | 0.023 | 0.031 | 0.033 | 0.034 | 0.032 |
| K₂O | 0.000 | 0.000 | 0.000 | 0.001 | 0.000 | 0.000 | 0.001 | 0.001 | 0.001 |
| MgO | 7.8 | 7.7 | 7.1 | 5.8 | 5.9 | 1.9 | 1.8 | 1.8 | 1.9 |
| CaO | 8.1 | 9.0 | 8.0 | 8.7 | 8.3 | 13.3 | 14.4 | 13.3 | 14.3 |
| SrO | 0.0 | 0.0 | 0.0 | 0.0 | 0.4 | 0.0 | 0.0 | 0.0 | 0.0 |
| BaO | 3.5 | 3.0 | 3.5 | 3.4 | 3.2 | 3.8 | 3.7 | 3.7 | 3.7 |
| SnO₂ | 0.1 | 0.1 | 0.1 | 0.1 | 0.1 | 0.1 | 0.1 | 0.1 | 0.1 |
| Fe₂O₃ | 0.0003 | 0.0002 | 0.0002 | 0.0003 | 0.0003 | 0.0002 | 0.0001 | 0.0002 | 0.0002 |
| TiO₂ | 0.000 | 0.000 | 0.000 | 0.000 | 0.000 | 0.000 | 0.000 | 0.000 | 0.000 |
| Li₂O+Na₂O+K₂O | 0.025 | 0.024 | 0.025 | 0.025 | 0.023 | 0.031 | 0.034 | 0.035 | 0.033 |
| (MgO+SrO+BaO)/CaO | 1.39 | 1.19 | 1.33 | 1.06 | 1.16 | 0.42 | 0.39 | 0.42 | 0.39 |
| ρ (g/cm³) | 2.58 | 2.57 | 2.55 | 2.55 | 2.55 | 2.61 | 2.62 | 2.60 | 2.62 |
| CTE₃₀₋₃₈₀ (×10⁻⁷/°C) | 42 | 42 | 42 | 42 | 42 | 46 | 48 | 47 | 48 |
| Tg (°C) | 696 | 692 | 675 | 676 | 678 | 686 | 685 | 679 | 677 |
| Tf (°C) | 757 | 752 | 733 | 734 | 735 | 744 | 743 | 737 | 731 |
| E (GPa) | 80 | 81 | 77 | 77 | 77 | 79 | 80 | 79 | 79 |
| Ps (°C) | 656 | 657 | 635 | 636 | 636 | 646 | 644 | 638 | 638 |
| Ta (°C) | 705 | 706 | 680 | 682 | 683 | 693 | 690 | 683 | 682 |
| Ts (°C) | 910 | 908 | 876 | 881 | 883 | 889 | 880 | 873 | 866.5 |
| 10^{4.0} dPa·s (°C) | 1,182 | 1,173 | 1,142 | 1,167 | 1,156 | 1,163 | 1,146 | 1, 148 | 1,134 |
| 10^{3.0} dPa·s (°C) | 1,326 | 1,315 | 1,282 | 1,305 | 1,298 | 1,306 | 1,285 | 1,291 | 1,274 |
| 10^{2.5} dPa·s (°C) | 1,419 | 1,407 | 1,373 | 1,397 | 1,390 | 1,399 | 1,376 | 1,386 | 1,366 |
| 10^{2.0} dPa·s (°C) | 1,535 | 1,516 | 1,484 | 1,506 | 1,503 | 1,512 | 1,489 | 1,503 | 1,480 |
| TL (°C) | 1,062 | 1,075 | 1,019 | 1,026 | 1,022 | 1,056 | 1,037 | 1,036 | 1,034 |
| logη (°C) | 5.2 | 5.0 | 5.3 | 5.4 | 5.4 | 5.1 | 5.1 | 5.1 | 5.0 |
| T254nm (%) | 36 | 38 | 40 | 40 | 51 | 56 | 48 | 49 | 54 |

First, a glass batch prepared by blending glass raw materials so that each glass composition listed in the tables was attained was placed in a platinum crucible, and was then melted at from 1,500°C to 1,700°C for from 3 hours to 24 hours. When the glass batch was dissolved, molten glass was stirred to be homogenized by using a platinum stirrer. Next, the molten glass was poured out on a carbon sheet and formed into a sheet shape, and was then annealed at 3°C/min from a temperature higher than an annealing point by about 20°C to normal temperature. Each of the resultant samples was evaluated for its density ρ, average coefficient of thermal expansion CTE₃₀₋₃₈₀ within the temperature range of from 30°C to 380°C, Young's modulus E, glass transition point Tg, deformation point Tf, strain point Ps, annealing point Ta, softening point Ts, temperature at a viscosity at high temperature of 10^{4.0} dPa·s, temperature at a viscosity at high temperature of 10^{3.0} dPa·s, temperature at a viscosity at high temperature of 10^{2.5} dPa·s, temperature at a viscosity at high temperature of 10^{2.0} dPa·s, liquidus temperature TL, viscosity logη at the liquidus temperature, and transmittance T254 at a thickness of 1 mm at 254 nm.

The density ρ is a value measured by a well-known Archimedes method.

The average coefficient of thermal expansion CTE_{30- 380} within the temperature range of from 30°C to 380°C, the glass transition point Tg, and the deformation point Tf are values measured with a dilatometer.

The Young's modulus E refers to a value measured by a resonance method.

The strain point Ps, the annealing point Ta, and the softening point Ts are values measured in accordance with a method of ASTM C336.

The temperatures at viscosities at high temperature of 10^{4.0} dPa·s, 10^{3.0} dPa·s, and 10^{2.5} dPa·s are values measured by a platinum sphere pull up method.

The liquidus temperature TL is a value obtained as follows: glass powder, which has passed through a standard 30-mesh (500 um) sieve and remained on a 50-mesh (300 um) sieve, is placed in a platinum boat and kept for 24 hours in a temperature gradient furnace, and then a temperature at which a crystal precipitates is measured through observation with a microscope. The viscosity logη at the liquidus temperature is a value obtained by measuring the viscosity of the glass at the liquidus temperature TL by a platinum sphere pull up method.

The transmittance T254 at a thickness of 1 mm at 254 nm is a value including a reflection loss measured with a double beam-type spectrophotometer. The samples whose both surfaces were polished into optically polished surfaces (mirror surfaces) were used as measurement samples. A surface roughness Ra of a glass surface of each of those measurement samples was measured with an AFM, and as a result, was found to be from 0.5 nm to 1.0 nm in a measurement region of 5 µm×5 µm.

As apparent from the tables, Sample Nos. 1 to 69 each had a low coefficient of thermal expansion, had a high Young's modulus and high devitrification resistance, and also had a high transmittance at shorter wavelengths. Accordingly, it is conceived that Sample Nos. 1 to 69 are each suitable as a support glass substrate.

### Example 2

First, glass raw materials were blended so as to give the glass composition of each of Sample Nos. 1 to 69 shown in the tables, and were then supplied to a glass melting furnace and melted at from 1,600°C to 1,700°C. Next, the molten glass was supplied to an overflow down-draw forming apparatus and formed so as to have a sheet thickness of 0.8 mm. The total thickness variation (TTV) of the resultant glass substrate was reduced to less than 1 um by mechanically polishing both surfaces thereof. The obtained glass substrates were each processed into ϕ300 mm×0.8 mm in thickness, and both surfaces thereof were then subjected to polishing treatment with a polishing device. Specifically, both the surfaces of the glass substrate were sandwiched between a pair of polishing pads having different outer diameters, and both the surfaces of the glass substrate were subjected to polishing treatment while the glass substrate and the pair of polishing pads were rotated together. The polishing treatment was controlled so that part of the glass substrate sometimes protruded from the polishing pads. The polishing pads were each made of urethane, a polishing slurry used for the polishing treatment had an average particle diameter of 2.5 um, and a polishing rate was 15 m/min. The resultant glass substrates having been subjected to the polishing treatment were each measured for a total thickness variation (TTV) and a warpage level with a Bow/Warp measurement device SBW-331ML/d manufactured by Kobelco Research Institute, Inc. As a result, the total thickness variation (TTV) and warpage level of each of the glass substrates were found to be 0.85 µm or less and 35 µm or less, respectively.

### Reference Signs List

1, 27 laminate
10, 26 support glass substrate
11, 24 substrate to be processed
12 peeling layer
13, 21, 25 adhesive layer
20 supporting member
22 semiconductor chip
23 sealing material
28 wiring
29 solder bump

## Claims

1. A support glass substrate for supporting a substrate to be processed, the support glass substrate comprising, as a glass composition, in terms of mol%, 50% to 80% of SiO₂, 0% to 25% of Al₂O₃, 5.5% to 20% of B₂O₃, 0% to 5% of Li₂O+Na₂O+K₂O, 0% to 15% of MgO, 1% to 25% of CaO, 0% to 10% of SrO, and 0% to 10% of BaO, having a molar ratio (MgO+SrO+BaO)/CaO of 1.5 or less, and having an average coefficient of thermal expansion at from 30°C to 380°C of from 35×10⁻⁷/°C to 60×10⁻⁷/°C.

2. The support glass substrate for supporting a substrate to be processed according to claim 1, wherein the support glass substrate comprises, as the glass composition, in terms of mol%, 50% to 70% of SiO₂, 8% to 15% of Al₂O₃, 8% to 14% of B₂O₃, 0% to 5% of Li₂O+Na₂O+K₂O, 0% to 8% of MgO, 7% to 20% of CaO, 0% to 5% of SrO, and 0% to 5% of BaO, and has an average coefficient of thermal expansion at from 30°C to 380°C of from 38×10⁻⁷/°C to 55×10⁻⁷/°C.

3. The support glass substrate according to claim 1 or 2, wherein the support glass substrate has a transmittance at a thickness of 1 mm at 254 nm of 5% or more.

4. The support glass substrate according to any one of claims 1 to 3, wherein the support glass substrate has a Young's modulus of 70 GPa or more.

5. The support glass substrate according to any one of claims 1 to 4, wherein the support glass substrate has a liquidus viscosity of 10^{4.0} dPa·s or more.

6. The support glass substrate according to any one of claims 1 to 5, wherein the support glass substrate has a temperature at a viscosity at high temperature of 10^{2.5} dPa·s of less than 1,600°C.

7. The support glass substrate according to any one of claims 1 to 6, wherein the support glass substrate has a wafer shape having a diameter of from 100 mm to 500 mm, has a sheet thickness of less than 2.0 mm, has a total thickness variation (TTV) of 5 µm or less, and has a warpage level of 60 µm or less.

8. A laminate, comprising at least a substrate to be processed and a support glass substrate for supporting the substrate to be processed, wherein the support glass substrate is the support glass substrate of any one of claims 1 to 7.

9. The laminate according to claim 8, wherein the substrate to be processed comprises at least a semiconductor chip molded with a sealing material.

10. A method of manufacturing a laminate, comprising the steps of:
preparing the support glass substrate of any one of claims 1 to 7;
preparing a substrate to be processed; and
laminating the support glass substrate and the substrate to be processed on each other to obtain a laminate.

11. A method of manufacturing a semiconductor package, comprising the steps of:
preparing the laminate of claim 8 or 9; and
subjecting the substrate to be processed to processing treatment.

12. The method of manufacturing a semiconductor package according to claim 11, wherein the step of subjecting the substrate to be processed to processing treatment comprises arranging wiring on one surface of the substrate to be processed.

13. The method of manufacturing a semiconductor package according to claim 11 or 12, wherein the step of subjecting the substrate to be processed to processing treatment comprises forming a solder bump on one surface of the substrate to be processed.

14. A support glass substrate for supporting a substrate to be processed, the support glass substrate having a transmittance at a thickness of 1 mm at 254 nm of 5% or more, having an average coefficient of thermal expansion at from 30°C to 380°C of from 30×10⁻⁷/°C to 60×10⁻⁷/°C, having a sheet thickness of less than 5.0 mm, and having a total thickness variation (TTV) of 5 µm or less.
